# DEMANDE DE BREVET EUROPEEN

(11) **EP 2 706 565 A1**
(43) Date de publication de la demande: **12.03.2014**
(21) Numéro de dépôt: 13182553.1
(22) Date de dépôt: 02.09.2013
(51) Int. Cl.: H01L 21/762

(54) **Dispositif microélectronique à tranchées d'isolation débordant sous une zone activé**

(30) Priorité: 05.09.2012 FR 1258274
(71) Demandeur: Commissariat à l'Énergie Atomique et aux Énergies Alternatives, 75015 Paris (FR)
(72) Inventeur: Vinet, Maud, 38140 RIVES SUR FURE (FR); Grenouillet, Laurent, 38140 RIVES SUR FURE (FR); Le Tiec, Yannick, 38920 CROLLES (FR); Wacquez, Romain, 13008 MARSEILLE (FR)
(74) Mandataire: Ahner, Philippe

(57) **Abrégé**

Dispositif microélectronique (100) comportant :
- un substrat (102) comprenant une première couche de semi-conducteur (108) disposée sur une couche diélectrique (106) et une deuxième couche de semi-conducteur (104),
- une tranchée d'isolation (114) réalisée à travers la première couche de semi-conducteur, la couche diélectrique et une partie de l'épaisseur de la deuxième couche de semi-conducteur, comprenant un matériau diélectrique et délimitant, dans la première couche de semi-conducteur, une zone active (110) rectangulaire du dispositif, et dans lequel, au niveau de ladite partie de l'épaisseur de la deuxième couche de semi-conducteur, une partie (118) du matériau diélectrique de la tranchée d'isolation est disposée sous la zone active en formant deux parois latérales, deux autres parois latérales de la tranchée d'isolation n'étant pas disposées sous la zone active.

## Description

### DOMAINE TECHNIQUE

L'invention concerne le domaine des dispositifs microélectroniques réalisés dans un substrat de type semi-conducteur sur isolant et comportant des zones actives délimitées par des tranchées d'isolation, par exemple de type STI (« Shallow Trench Isolation »). L'invention est avantageusement utilisée pour la réalisation de transistors FDSOI (totalement déserté sur SOI) en technologie UTBB (« Ultra-Thin Body and Box »).

### ETAT DE LA TECHNIQUE ANTERIEURE

La réalisation de dispositifs microélectroniques, tels que des transistors, dans un substrat de type semi-conducteur sur isolant, comporte la réalisation de tranchées d'isolation, par exemple de type STI, permettant d'isoler électriquement les zones actives des dispositifs les unes vis-à-vis des autres.

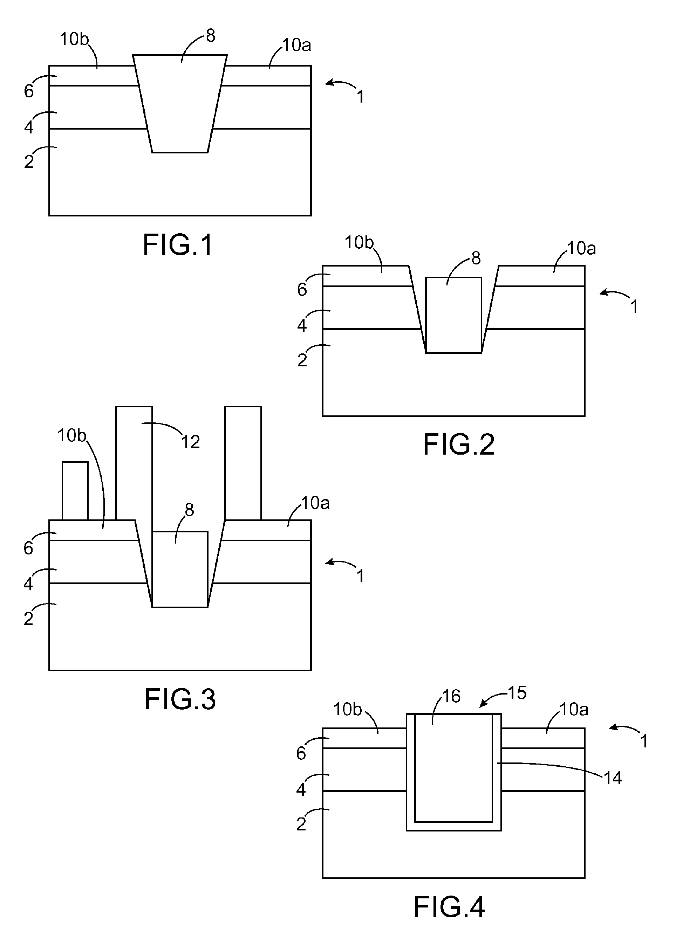

Le motif des tranchées d'isolation réalisées dans le substrat est complémentaire de celui des zones actives des dispositifs. Un exemple d'une tranchée d'isolation 8 de type STI est représenté sur la figure 1. Cette tranchée 8 est réalisée dans un substrat SOI 1 comportant une couche support, ou couche épaisse, de semi-conducteur 2, typiquement composée de silicium, recouverte d'une couche mince diélectrique 4 appelée BOX (« Burried Oxide ») et d'une couche mince, ou couche superficielle, de semi-conducteur 6, également composée de silicium, dans laquelle les zones actives des dispositifs sont destinées à être réalisées. La tranchée d'isolation 8 délimite ici deux zones actives 10a et 10b de deux transistors réalisées dans la couche mince de semi-conducteur 6. La tranchée d'isolation 8, composée d'un matériau diélectrique tel que du SiO₂, traverse toute l'épaisseur de la couche mince de semi-conducteur 6 et de la couche mince diélectrique 4, et une partie de l'épaisseur de la couche support de semi-conducteur 2.

Lors de la réalisation de dispositifs microélectroniques dans le substrat 1, après avoir formé la tranchée d'isolation 8, le substrat 1 subit généralement plusieurs étapes de nettoyage et de gravure qui peuvent détériorer la tranchée d'isolation 8, comme par exemple des étapes de nettoyage réalisées avec une solution d'acide fluorhydrique et mises en oeuvre après une gravure de grille ou préalablement à des étapes de siliciuration ou d'épitaxie. L'oxyde de semi-conducteur de la tranchée d'isolation 8 est dégradé par ces étapes et retiré partiellement, à la fois verticalement et horizontalement (voir la figure 2 sur laquelle le matériau diélectrique de la tranchée d'isolation 8 est partiellement retiré). Or, une telle dégradation de la tranchée d'isolation 8 peut engendrer des problèmes d'isolation électrique entre la couche support 2 et la couche mince 6, notamment lors de la réalisation ultérieure de contacts électriques à proximité de la tranchée d'isolation 8. Sur l'exemple de la figure 3, un contact électrique 12 est destiné à contacter électriquement une partie de la zone active 10b se trouvant à proximité de la tranchée d'isolation 8, correspondant par exemple à une région de source ou de drain d'un transistor réalisé dans la zone active 10b. Or, dans les noeuds technologiques actuels, compte tenu de la distance réduite entre deux zones actives (égale à environ 50 nm en technologie 20 nm) qui correspond à la largeur d'une tranchée d'isolation, un léger désalignement lors de la lithographie réalisée pour former ce contact électrique 12 peut entraîner un décalage de ce contact électrique 12 sur la tranchée d'isolation 8. Un tel décalage peut également être intentionnel, certains contacts électriques étant réalisés en débordant volontairement sur la tranchée d'isolation 8. Or, compte tenu du retrait partiel du SiO₂ de la tranchée d'isolation 8, ce décalage peut entraîner un court-circuit entre la zone active 10b formée dans la couche mince de semi-conducteur 6 et la couche support de semi-conducteur 2 (sur l'exemple de la figure 3, une partie du contact électrique 12 se retrouve dans un creux formé par le retrait partiel du matériau diélectrique de la tranchée d'isolation 8, court-circuitant ainsi la couche mince 6 avec la couche support 2).

Afin de résoudre ce problème de dégradation des tranchées d'isolation, une solution représentée sur la figure 4 consiste, lors de la réalisation d'une tranchée d'isolation 15, à recouvrir tout d'abord les parois (parois latérales + paroi de fond) de la tranchée par une fine couche 14 (« liner ») composée d'un matériau diélectrique plus résistant que l'oxyde de semi-conducteur utilisé pour réaliser la tranchée d'isolation 8, par exemple du nitrure de silicium.

L'espace restant de la tranchée est ensuite rempli par de l'oxyde de silicium 16.

Les parties de la couche 14 de SiN formant les parois latérales de la tranchée d'isolation 15 renforce la résistance de la tranchée d'isolation 15 vis-à-vis de ces étapes de nettoyage et de gravure.

Toutefois, bien que cette solution évite en partie de dégrader la tranchée d'isolation, elle ne permet pas d'éliminer totalement le risque de court-circuit exposé précédemment. En effet, lors de la gravure des contacts électriques, il est nécessaire de graver une mince couche de nitrure (appelée « contact etch stop layer ») présente, ce qui va entrainer la gravure simultanée de la couche 14 de nitrure et donc anéantir le scellement réalisé par le nitrure de cette couche 14. De plus, lorsque la couche 14 est composée d'un diélectrique à haute permittivité, des dégradations des performances électriques sont observées du fait d'une diffusion d'oxygène se produisant à travers ce liner.

### EXPOSÉ DE L'INVENTION

Un but de la présente invention est de proposer un dispositif microélectronique comprenant au moins une zone active délimitée par une tranchée d'isolation qui soit résistante vis-à-vis d'étapes pouvant dégrader le ou les matériaux de la tranchée d'isolation, qui permette d'éviter les courts-circuits dans le substrat même en cas de retrait partiel des matériaux de la tranchée d'isolation.

Pour cela, il est proposé un dispositif microélectronique comportant au moins :
- un substrat comprenant une première couche de semi-conducteur disposée sur une couche diélectrique, la couche diélectrique étant disposée sur une deuxième couche de semi-conducteur,
- une tranchée d'isolation réalisée à travers la première couche de semi-conducteur, la couche diélectrique et une partie de l'épaisseur de la deuxième couche de semi-conducteur, comprenant au moins un matériau diélectrique et délimitant, dans la première couche de semi-conducteur, au moins une zone active du dispositif,
et dans lequel, au niveau de ladite partie de la deuxième couche de semi-conducteur, au moins une partie du matériau diélectrique de la tranchée d'isolation est disposée, ou s'étend, sous la zone active.

Il est également proposé un dispositif microélectronique comportant au moins :
- un substrat comprenant une première couche de semi-conducteur disposée sur une couche diélectrique, la couche diélectrique étant disposée sur une deuxième couche de semi-conducteur,
- une tranchée d'isolation réalisée à travers la première couche de semi-conducteur, la couche diélectrique et une partie de l'épaisseur de la deuxième couche de semi-conducteur, comprenant au moins un matériau diélectrique et délimitant au moins une zone active du substrat,
et dans lequel, au niveau d'au moins une partie de la tranchée d'isolation, l'épaisseur de la tranchée d'isolation dans la deuxième couche de semi-conducteur est supérieure à l'épaisseur de la tranchée d'isolation dans la première couche de semi-conducteur.

La présente invention concerne un dispositif microélectronique comportant au moins :
- un substrat comprenant une première couche de semi-conducteur disposée sur une couche diélectrique, la couche diélectrique étant disposée sur une deuxième couche de semi-conducteur,
- une tranchée d'isolation réalisée à travers la première couche de semi-conducteur, la couche diélectrique et une partie de l'épaisseur de la deuxième couche de semi-conducteur, comprenant au moins un matériau diélectrique et délimitant, dans la première couche de semi-conducteur, au moins une zone active du dispositif,
dans lequel, au niveau de ladite partie de l'épaisseur de la deuxième couche de semi-conducteur, au moins une partie du matériau diélectrique de la tranchée d'isolation est disposée sous la zone active, la zone active étant de forme sensiblement rectangulaire et étant délimitée par au moins quatre parois latérales de la tranchée d'isolation qui s'étendent à travers la première couche de semi-conducteur, la couche diélectrique et ladite partie de l'épaisseur de la deuxième couche de semi-conducteur,
et dans lequel, au niveau de ladite partie de l'épaisseur de la deuxième couche de semi-conducteur, deux des quatre parois latérales qui sont sensiblement parallèles l'une par rapport à l'autre sont disposées sous la zone active et les deux autres parois latérales ne sont pas disposées sous la zone active.

Ainsi, la tranchée d'isolation comporte, au niveau de la couche support, c'est-à-dire de la deuxième couche de semi-conducteur, une ou plusieurs régions diélectriques plus épaisses qui s'étendent sous la zone active, notamment là où il existe un risque de court-circuit et/ou là où l'épaisseur du diélectrique n'a pas ou peu d'impact sur les caractéristiques électriques du dispositif semi-conducteur, par exemple au niveau des régions de source et de drain du transistor. En cas de retrait partiel d'une partie du matériau diélectrique de la tranchée d'isolation, les régions diélectriques plus épaisses de la tranchée d'isolation permettent d'assurer une isolation électrique de la deuxième couche de semi-conducteur vis-à-vis d'un ou plusieurs contacts électriques qui déborderaient sur la tranchée d'isolation.

Une telle tranchée d'isolation comporte donc une ou plusieurs parois latérales qui, au niveau de la deuxième couche de semi-conducteur, ne sont pas alignées verticalement avec la zone active délimitée par la tranchée d'isolation.

Ladite partie du matériau diélectrique de la tranchée d'isolation peut être en contact avec une partie de la couche diélectrique qui est disposée sous la zone active.

Ledit matériau diélectrique de la tranchée d'isolation peut être du SiO₂.

La zone active est de forme sensiblement rectangulaire et est délimitée par au moins quatre parois latérales de la tranchée d'isolation qui s'étendent à travers la première couche de semi-conducteur, la couche diélectrique et ladite partie de l'épaisseur de la deuxième couche de semi-conducteur, et, au niveau de ladite partie de l'épaisseur de la deuxième couche de semi-conducteur, deux des quatre parois latérales qui sont sensiblement parallèles l'une par rapport à l'autre sont disposées sous la zone active et les deux autres parois latérales ne sont pas disposées sous la zone active. Dans cette configuration, ladite partie du matériau diélectrique de la tranchée d'isolation qui est disposée sous la zone active correspond notamment aux deux parois latérales qui sont disposées, ou s'étendent, sous la zone active. Ces deux parois latérales peuvent être en contact avec une partie de la couche diélectrique qui est disposée sous la zone active.

Ainsi, une telle tranchée d'isolation comprend un profil asymétrique tel qu'au niveau de la deuxième couche de semi-conducteur (la couche support du substrat), au moins une des parois latérales se trouve, ou s'étend, sous la zone active afin d'éviter les courts-circuits dans le substrat même en cas de retrait partiel du ou des matériaux de la tranchée d'isolation, et au moins une autre des parois latérales ne se trouve pas sous la zone active afin de ne pas modifier les dimensions du ground plane (partie de la couche support se trouvant sous la zone active, et notamment sous la région de canal) du dispositif microélectronique. Selon différentes variantes, il est possible d'avoir une seule des parois latérales qui se trouve, ou s'étend, sous la zone active et les trois autres parois latérales qui ne se trouvent pas, ou ne s'étendent pas, sous la zone active. Il est également possible d'avoir trois des parois latérales qui se trouvent, ou s'étendent, sous la zone active et une autre des parois latérales qui ne se trouve pas, ou ne s'étend pas, sous la zone active.

La zone active peut être de forme sensiblement rectangulaire et être délimitée par au moins quatre parois latérales de la tranchée d'isolation, et l'épaisseur du matériau diélectrique de deux des quatre parois latérales de la tranchée, qui sont sensiblement parallèles l'une par rapport à l'autre, peut être supérieure à l'épaisseur du matériau diélectrique des deux autres parois latérales de la tranchée.

Le dispositif peut comporter en outre au moins un transistor réalisé dans la zone active et dont une grille peut être disposée sur une partie de la zone active et sur une partie desdites deux autres parois latérales. Les parois latérales qui sont orientées sensiblement perpendiculairement à la grille peuvent correspondre à celles qui ne s'étendent pas sous la zone active (et notamment sous la région de canal du transistor, et qui sont donc alignées verticalement avec la zone active) afin de ne pas réduire les dimensions du ground plane du transistor, et donc ne pas décaler la tension de seuil du transistor par rapport à sa valeur nominale. De plus, on limite également la dégradation des effets de canaux courts du fait que l'épaisseur du diélectrique enterré se trouvant sous le canal n'est pas modifiée.

En variante, la zone active peut être de forme sensiblement rectangulaire et être délimitée par des parois latérales de la tranchée d'isolation qui s'étendent à travers la première couche de semi-conducteur, la couche diélectrique et ladite partie de l'épaisseur de la deuxième couche de semi-conducteur, et, au niveau de ladite partie de la deuxième couche de semi-conducteur, les parois latérales de la tranchée d'isolation peuvent être disposées sous la zone active.

Dans cette variante, au niveau de la deuxième couche de semi-conducteur, toutes les parois latérales de la tranchée d'isolation peuvent donc « déborder » sous la zone active, et être en contact avec une partie de la couche diélectrique qui est disposée sous la zone active. Ainsi, dans cette variante, au niveau de la deuxième couche de semi-conducteur, aucune des parois latérales de la tranchée d'isolation n'est alignée verticalement avec la zone active délimitée par la partie de la tranchée d'isolation se trouvant au niveau de la première couche de semi-conducteur.

Une paroi de fond de la tranchée peut être à base d'au moins un matériau diélectrique.

Au niveau de la couche diélectrique et de la première couche de semi-conducteur, les parois latérales peuvent être formées d'au moins une couche de nitrure de semi-conducteur, ou de diélectrique à haute permittivité ou high-k (présentant une constante diélectrique supérieure à environ 3,9). Un tel liner peut donc former la partie supérieure des parois latérales de la tranchée d'isolation.

L'épaisseur du matériau diélectrique de ladite première des parois latérales de la tranchée peut être supérieure à environ 5 fois l'épaisseur du matériau diélectrique de ladite deuxième des parois latérales de la tranchée.

Il est proposé également un procédé de réalisation d'un dispositif microélectronique, comportant au moins la réalisation, dans un substrat comprenant une première couche de semi-conducteur disposée sur une couche diélectrique, la couche diélectrique étant disposée sur une deuxième couche de semi-conducteur, d'au moins une tranchée d'isolation à travers la première couche de semi-conducteur, la couche diélectrique et une partie de l'épaisseur de la deuxième couche de semi-conducteur, comprenant au moins un matériau diélectrique et délimitant, dans la première couche de semi-conducteur, au moins une zone active du dispositif,
et comportant, lors de la réalisation de la tranchée d'isolation, la réalisation d'une partie du matériau diélectrique de la tranchée d'isolation, au niveau de ladite partie de la deuxième couche de semi-conducteur, sous la zone active.

Il est également proposé un procédé de réalisation d'un dispositif microélectronique, comportant au moins les étapes de :
- réalisation, dans un substrat comprenant une première couche de semi-conducteur disposée sur une couche diélectrique, la couche diélectrique étant disposée sur une deuxième couche de semi-conducteur, d'au moins une tranchée d'isolation à travers la première couche de semi-conducteur, la couche diélectrique et une partie de l'épaisseur de la deuxième couche de semi-conducteur, telle que la tranchée délimite au moins une zone active du dispositif,
- réalisation, dans ladite partie de l'épaisseur de la deuxième couche de semi-conducteur, d'au moins une paroi latérale de la tranchée d'isolation comprenant au moins un matériau diélectrique et telle que l'épaisseur de la tranchée dans la deuxième couche de semi-conducteur soit supérieure à l'épaisseur de la tranchée d'isolation dans la première couche de semi-conducteur.

La présente invention concerne en outre un procédé de réalisation d'un dispositif microélectronique, comportant au moins la réalisation, dans un substrat comprenant une première couche de semi-conducteur disposée sur une couche diélectrique, la couche diélectrique étant disposée sur une deuxième couche de semi-conducteur, d'au moins une tranchée d'isolation à travers la première couche de semi-conducteur, la couche diélectrique et une partie de l'épaisseur de la deuxième couche de semi-conducteur, comprenant au moins un matériau diélectrique et délimitant, dans la première couche de semi-conducteur, au moins une zone active du dispositif,
et comportant, lors de la réalisation de la tranchée d'isolation, la réalisation d'une partie du matériau diélectrique de la tranchée d'isolation, au niveau de ladite partie de l'épaisseur de la deuxième couche de semi-conducteur, sous la zone active, la zone active étant de forme sensiblement rectangulaire et étant délimitée par au moins quatre parois latérales de la tranchée d'isolation qui s'étendent à travers la première couche de semi-conducteur, la couche diélectrique et ladite partie de l'épaisseur de la deuxième couche de semi-conducteur, et dans lequel, au niveau de ladite partie de l'épaisseur de la deuxième couche de semi-conducteur, deux des quatre parois latérales qui sont sensiblement parallèles l'une par rapport à l'autre sont disposées sous la zone active et les deux autres parois latérales ne sont pas disposées sous la zone active.

La réalisation de la tranchée d'isolation peut comporter au moins la mise en oeuvre des étapes suivantes :
- gravure d'une tranchée à travers la première couche de semi-conducteur, la couche diélectrique et ladite partie de l'épaisseur de la deuxième couche de semi-conducteur,
- implantation d'oxygène et/ou de fluor dans une ou plusieurs parois latérales de la tranchée, au niveau de la deuxième couche de semi-conducteur,
- recuit du substrat, formant ladite partie du matériau diélectrique de la tranchée d'isolation disposée sous la zone active dans ladite partie de l'épaisseur de la deuxième couche de semi-conducteur.

Le recuit peut être mis en oeuvre sous atmosphère de dioxygène.

L'implantation d'oxygène et/ou de fluor peut être réalisée par des faisceaux d'ions d'énergie comprise entre environ 0,5 keV et 40 keV et/ou dont la dose est comprise entre environ 5.10¹³ at.cm² et 5.10¹⁶ at.cm², orientés en formant un angle non nul avec ladite une ou plusieurs parois latérales de la tranchée. L'énergie du ou des faisceaux d'ions est de préférence comprise entre environ 0,5 keV et 10 keV afin d'éviter d'induire des modifications notables des propriétés de la première couche de semi-conducteur. En utilisant des faisceaux d'ions à faible énergie et à dose modérée, on réduit le risque de défauts et de dislocations dans le semi-conducteur qui subi l'implantation d'oxygène et/ou de fluor sous forme d'ions. De plus, l'implantation peut dans ce cas être réalisée dans une seule direction afin que seule une partie des parois latérales de la tranchée d'isolation s'étendent sous la zone active.

L'implantation d'oxygène et/ou de fluor peut être également réalisée dans une paroi de fond de la tranchée.

Le procédé peut comporter en outre, au cours de la réalisation de la tranchée d'isolation, une étape de réalisation d'au moins une couche de nitrure de semi-conducteur formant des parois latérales de la tranchée d'isolation au niveau de la couche diélectrique et de la première couche de semi-conducteur.

Le procédé peut comporter en outre, après la réalisation des parois latérales de la tranchée d'isolation, une étape de remplissage de la tranchée par au moins un matériau diélectrique.

La zone active est de forme sensiblement rectangulaire et est délimitée par au moins quatre parois latérales de la tranchée d'isolation qui s'étendent à travers la première couche de semi-conducteur, la couche diélectrique et ladite partie de l'épaisseur de la deuxième couche de semi-conducteur, et, au niveau de ladite partie de l'épaisseur de la deuxième couche de semi-conducteur, deux des quatre parois latérales qui sont sensiblement parallèles l'une par rapport à l'autre sont disposées sous la zone active et les deux autres parois latérales ne sont pas disposées sous la zone active.

Le procédé peut comporter en outre, après la réalisation de la tranchée d'isolation, une étape de réalisation d'au moins un transistor dans la zone active et dont une grille peut être disposée sur une partie de la zone active et sur une partie desdites deux autres parois latérales.

Dans une variante, la zone active peut être de forme sensiblement rectangulaire et être délimitée par des parois latérales de la tranchée d'isolation qui s'étendent à travers la première couche de semi-conducteur, la couche diélectrique et ladite partie de l'épaisseur de la deuxième couche de semi-conducteur, et, au niveau de ladite partie de la deuxième couche de semi-conducteur, lesdites parois latérales de la tranchée d'isolation peuvent être disposées sous la zone active.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4 représentent des tranchées d'isolation selon l'art antérieur,
- les figures 5 à 7 représentent un dispositif microélectronique, objet de la présente invention, selon un premier mode de réalisation,
- les figures 8 à 15B représentent des étapes d'un procédé de réalisation d'un dispositif microélectronique, objet de la présente invention, selon le premier mode de réalisation,
- les figures 16 à 18 représentent un dispositif microélectronique selon un exemple illustratif.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

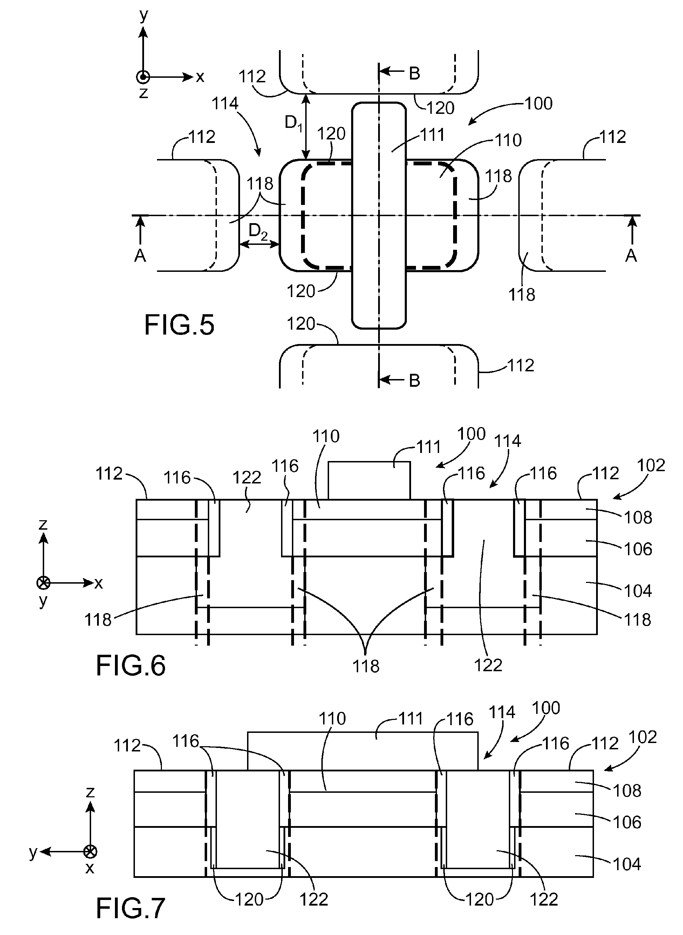

On se réfère tout d'abord aux figures 5 à 7 qui représentent schématiquement un dispositif microélectronique 100, ici un transistor FDOI de type UTBB, selon un premier mode de réalisation. La figure 5 est une vue de dessus du transistor 100, les figures 6 et 7 étant des vues en coupe respectivement selon les axes AA et BB représentés sur la figure 5.

Le transistor 100 est réalisé dans un substrat 102 de type SOI, comportant une couche support, ou couche épaisse, de semi-conducteur 104, par exemple à base de silicium, d'une couche mince diélectrique 106 (BOX), par exemple à base de SiO₂, et d'une couche mince, ou couche superficielle, de semi-conducteur 108, ici de silicium. Une région de la couche mince de semi-conducteur 108 forme une zone active 110 du transistor 100 comprenant un canal et des régions de source et de drain du transistor 100. Une grille 111 du transistor 100 est réalisée sur la zone active 110.

D'autres zones actives 112 de différents dispositifs sont également réalisées dans le substrat 102 et représentées sur les figures 5 à 7. La zone active 110 est isolée des autres zones actives 112 par une tranchée d'isolation 114 dont le motif est complémentaire de celui de l'ensemble des zones actives réalisées dans le substrat 102. La distance entre deux zones actives (correspondant aux distances D₁ et D₂ représentées sur la figure 5) correspond à la largeur de la tranchée d'isolation 114, et est par exemple comprise entre environ 40 nm et 1 µm. Pour des dispositifs microélectroniques réalisés en technologie 20 nm, la largeur de la tranchée d'isolation 114 est par exemple comprise entre environ 40 nm et 200 nm. La tranchée d'isolation 114 délimite la zone active 110.

La tranchée d'isolation 114 est réalisée à travers la couche mince de semi-conducteur 108, la couche mince diélectrique 106 ainsi que dans une partie de l'épaisseur de la couche support de semi-conducteur 104. Au niveau de la couche mince de semi-conducteur 108 et de la couche mince diélectrique 106, les parois latérales de la tranchée d'isolation 114 sont formées par une couche diélectrique 116 à base de nitrure de semi-conducteur, ici du SiN, ou encore formée d'un bicouche SiN/SiO₂, ou bien comprenant un oxyde à forte permittivité tel que de l'HFO₂ ou de l'HFSiON. Cette couche diélectrique 116, dont l'épaisseur est par exemple comprise entre environ 5 nm et 15 nm, permet notamment d'empêcher, lors de la réalisation de la tranchée d'isolation 114 qui sera décrite plus loin, une oxydation du semi-conducteur de la couche mince 108. Pour des raisons de clarté des dessins, cette couche 116 n'est pas visible sur la figure 5.

Au niveau de la couche support de semi-conducteur 104, les parois latérales de la tranchée d'isolation 114 sont formées par des portions de matériau diélectrique, ici du SiO₂ dont l'épaisseur varie suivant l'orientation de ces parois vis-à-vis de la grille 111 du transistor 100. En effet, autour de la zone active 110 qui est de forme rectangulaire, la tranchée d'isolation 114 comporte quatre parois latérales sensiblement parallèles deux à deux. Au niveau des parois latérales de la tranchée d'isolation 114 qui ne sont pas recouvertes par la grille 111, c'est-à-dire qui ne croisent pas la grille 111 (ces parois latérales étant orientées parallèlement à la grille 111 qui s'étend dans une direction, correspondant à l'axe y sur les figures 5 à 7), des portions diélectriques 118 dont l'épaisseur (dimension selon l'axe x) est comprise entre environ 5 nm et 10 nm forment les parois latérales de la tranchée d'isolation 114 au niveau de la couche support de semi-conducteur 104. L'épaisseur des portions diélectriques 118, qui dépend du design de conception et notamment de la distance entre deux zones actives, peut être comprise entre environ 5 nm et 50 nm. Ces portions 118 sont notamment disposées sous la zone active 110 (voir figure 6). Les portions 118 sont en contact avec la partie de la couche diélectrique 106 se trouvant sous la zone active 110.

Par contre, au niveau des parois latérales de la tranchée qui sont orientées perpendiculairement à la grille 111, des fines portions 120 de matériau diélectriques (épaisseur comprise entre environ 1 nm et 2 nm) forment les parois latérales de la tranchée d'isolation 114 au niveau de la couche support 104 de semi-conducteur. Ces portions de matériau diélectrique 120 ne sont pas disposées sous la zone active 110 compte tenu de leur faible épaisseur. Les portions de matériau diélectrique 118, 120 formant les parois latérales de la tranchée d'isolation 114 sont représentées symboliquement en pointillés sur la figure 5.

Le reste de la tranchée d'isolation 114 est rempli d'un matériau diélectrique 122, tel que du SiO₂.

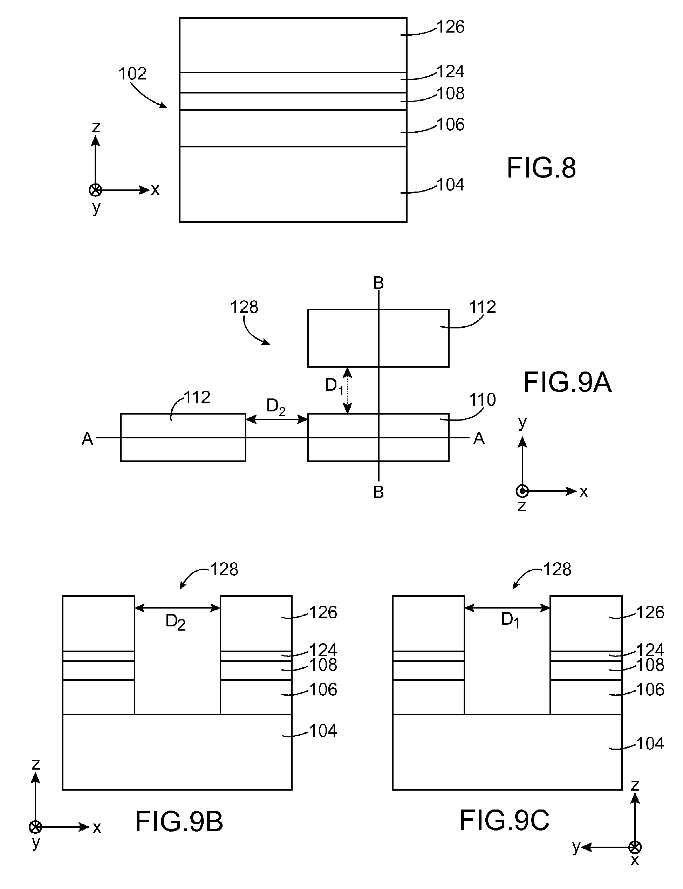

On décrit maintenant en liaison avec les figures 8 à 15 les étapes d'un procédé de réalisation du dispositif microélectronique 100, ici un transistor FDSOI, selon le premier mode de réalisation.

Le transistor 100 est réalisé à partir d'un empilement pre-STI standard comprenant le substrat SOI 102 sur lequel sont empilées une couche d'oxyde (par exemple du SiO₂) 124 et une couche de nitrure (ici du SiN) 126. Les couches de cet empilement représenté sur la figure 8 ont par exemple les épaisseurs suivantes :
- couche de nitrure 126 : 80 nm, ou encore comprise entre environ 50 nm et 100 nm,
- couche d'oxyde 124 : 10 nm, ou comprise entre environ 3 nm et 10 nm,
- couche mince de silicium 108 : 7 nm,
- couche mince diélectrique 106 : 25 nm,
- couche épaisse de silicium 104 : 700 µm.

Les épaisseurs indiquées ci-dessus sont données à titre indicatif pour un transistor 100 réalisé en technologie UTBB 20 nm. Ces épaisseurs peuvent toutefois varier selon les options de réalisation envisagées ainsi que du noeud technologique dans lequel le dispositif est réalisé.

Une tranchée 128, dont le motif est complémentaire de celui des zones actives à réaliser dans le substrat, est gravée, par exemple via une gravure anisotrope, à travers la couche de nitrure 126, la couche d'oxyde 124, la couche mince de semi-conducteur 108 et la couche mince diélectrique 106 (mais pas à travers la couche épaisse 104). Sur l'exemple des figures 9A à 9C (les figures 9B et 9C représentent respectivement des vues en coupe selon les axes AA et BB représentés sur la figure 9A), la zone active 110 du transistor 100 est espacée des autres zones actives 112 d'une distance D₁ ou D₂ comprise entre environ 40 nm et 50 nm, correspondant à la largeur de la tranchée 128.

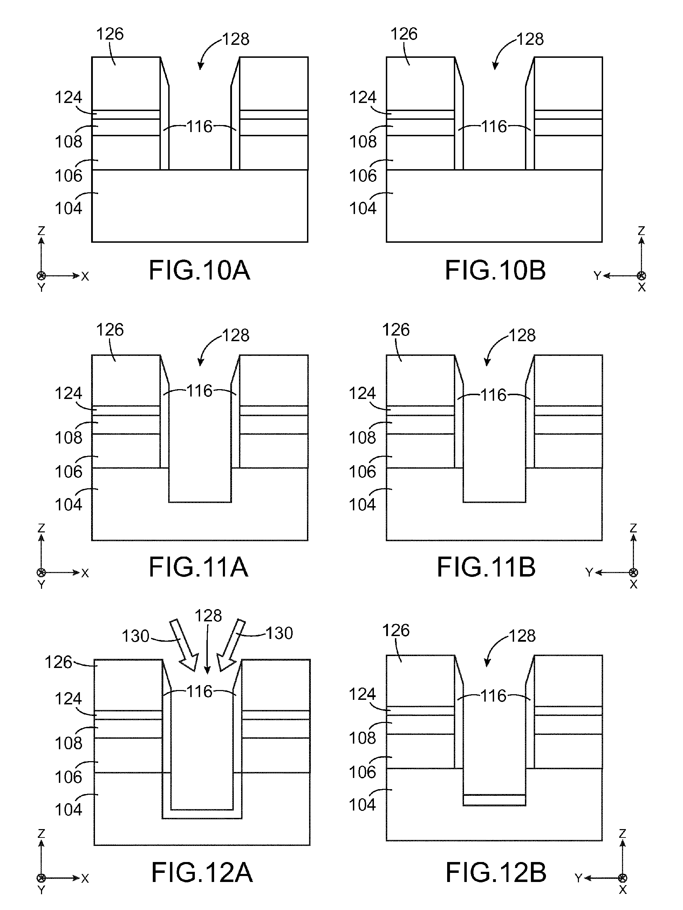

Les parois latérales de la tranchée 128 sont ensuite protégées en les recouvrant de la couche diélectrique 116 comprenant par exemple du nitrure de semi-conducteur, ici du SiN (figures 10A et 10B). La couche diélectrique 116 est réalisée sous la forme d'un espaceur autour des portions restantes des couches 126, 124, 108 et 106, par exemple avec une épaisseur comprise entre environ 3 nm et 15 nm.

Comme représenté sur les figures 11A et 11B, la tranchée 128 est ensuite prolongée à travers une partie de l'épaisseur de la couche support de semi-conducteur 104. Dans l'exemple décrit ici, la profondeur totale de la tranchée 128 est par exemple égale à environ 200 nm, ou comprise entre environ 100 nm et 300 nm.

Comme représenté sur les figures 12A et 12B, on réalise ensuite une implantation d'oxygène et/ou de fluor, et/ou de tout autre élément fortement électronégatif et/ou favorisant l'oxydation du semi-conducteur de la couche support 104, dans une partie des parois latérales de la tranchée 128, au niveau de la couche support de semi-conducteur 104. Dans le premier mode de réalisation décrit ici, cette implantation est réalisée seulement dans les parois latérales destinées à être orientées parallèlement à la grille du transistor 100, c'est-à-dire s'étendant parallèlement à l'axe y. Une telle implantation est réalisée via des faisceaux d'ions 130 formant un angle nul avec le plan (X,Z). Ainsi, les faisceaux d'ions 130 ne réalisent pas d'implantation dans les parois latérales de la tranchée 128 s'étendant parallèlement à l'axe X. Les faisceaux 130 forment par exemple un angle égal à environ 15° par rapport à la normale au substrat 102 (c'est-à-dire un angle d'environ 15° par rapport à l'axe z). L'angle des faisceaux 130 sera adapté en fonction de la profondeur de la tranchée 128 et de ses dimensions latérales (largeur), et peut être par exemple compris entre environ 5° et 30°.

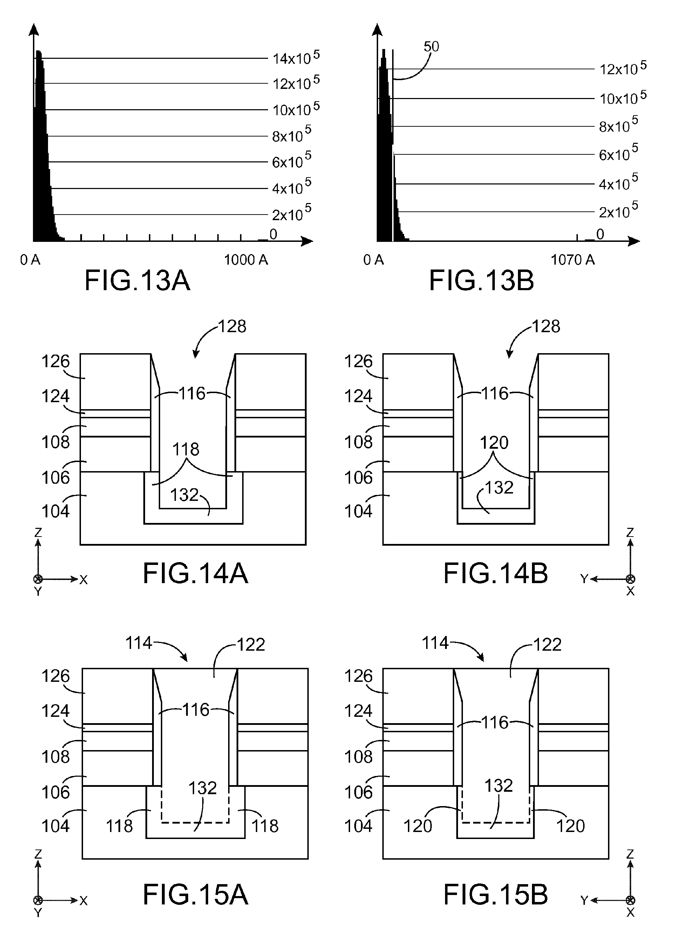

La couche de nitrure 116 formée le long des parois latérales de la tranchée 128, au niveau des couches 106, 108, 124 et 126 de l'empilement, protège notamment la couche mince de silicium 108 des faisceaux 130, empêchant ainsi l'implantation d'oxygène et/ou de fluor dans la couche mince de silicium 108. A titre d'illustration, les figures 13A et 13B représentent les rapports de concentrations at.cm⁻³/at.cm⁻² obtenus respectivement dans du silicium (figure 13A) et dans du silicium recouvert d'une couche de SiN d'épaisseur égale à environ 6 nm (figure 13B), en fonction de la profondeur dans le ou les matériaux implantés. On voit sur la figure 13B que le silicium (la référence 50 correspond à la limite SiN / Silicium) ne subit quasiment pas l'implantation d'oxygène réalisée.

Toute la paroi de fond de la tranchée 128 est également implantée de manière analogue aux parois latérales qui s'étendent parallèlement à l'axe y, au niveau de la couche support de semi-conducteur 104.

L'implantation est réalisée à faible énergie (par exemple à 1 keV), avec une dose modérée, supérieure à environ 1.10¹⁵ at.cm⁻², et par exemple égale à environ 5.10¹⁵ at.cm⁻² . Ainsi, on obtient dans les parois latérales de semi-conducteur implantées, sur une profondeur allant jusqu'à par exemple 5 nm, une concentration en espèces implantées (par exemple oxygène et/ou fluor) supérieure à environ 1.10¹⁸ at.cm⁻³ , et par exemple comprise entre environ 1.10²⁰ et 5.10²¹ at.cm⁻³.

On réalise ensuite un recuit oxydant (c'est-à-dire sous atmosphère d'oxygène) de l'ensemble précédemment réalisé, transformant ainsi le silicium implanté d'oxygène et/ou de fluor en SiO₂ (le fluor implanté permettant d'accélérer la réaction d'oxydation du silicium). Comme représenté sur la figure 14A, on obtient, au niveau des parois latérales et de la paroi de fond qui comportent de l'oxygène implanté, des portions diélectriques 118 formant, au niveau de la couche support de semi-conducteur 104, des parois latérales de la tranchée disposées sous la zone active 110, et une portion diélectrique 132 formant la paroi de fond de la tranchée d'isolation. Les portions 118 et 132 ont une épaisseur par exemple comprise entre environ 5 nm et 10 nm. Bien que les parois latérales, au niveau de la couche support de semi-conducteur 104, de la tranchée 128 orientées parallèlement à l'axe x ne soient pas implantées par de l'oxygène et/ou du fluor, le recuit oxydant réalise tout de même une faible oxydation de ces parois, formant des fines portions 120 de SiO₂ d'épaisseur comprise entre environ 1 nm et 2 nm (figure 14B). Compte tenu de leur faible épaisseur, ces portions 120 ne sont pas disposées sous la zone active 110. Ce recuit est par exemple réalisé à une température d'environ 1000°C, pendant environ 30 secondes. Ainsi, le fait d'avoir implanté de l'oxygène et/ou du fluor dans seulement une partie des parois latérales de la tranchée permet de créer une asymétrie dans l'épaisseur de diélectrique créé formant les parois latérales de la tranchée d'isolation.

Enfin, comme représenté sur les figures 15A et 15B, on achève la réalisation de la tranchée d'isolation 114 en remplissant l'espace restant de la tranchée 128 par un matériau diélectrique tel que du SiO₂. Les portions de matériau diélectrique qui se retrouvent déposées en dehors de la tranchée sont gravées en réalisant par exemple une CMP, la couche diélectrique 126 servant de couche d'arrêt à cette planarisation.

Les couches 124 et 126 sont ensuite retirées afin de révéler la couche mince de semi-conducteur 108. Les différents éléments du transistor 100 sont ensuite réalisés à partir de la couche mince de semi-conducteur 108 (diélectrique de grille, grille, création des régions de source et drain, ...).

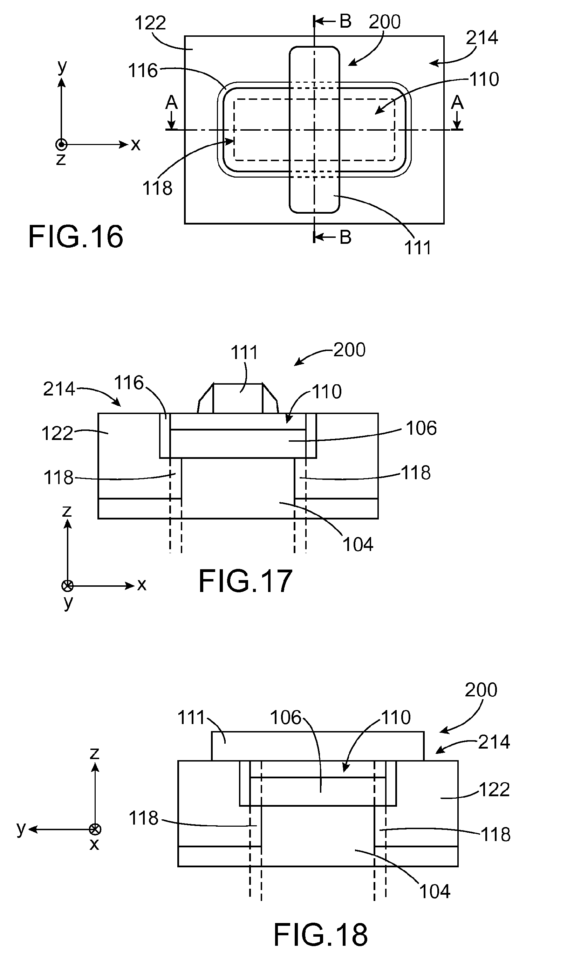

Les figures 16 à 18 représentent schématiquement un dispositif microélectronique 200, ici un transistor FDOI de type UTBB, selon un exemple illustratif. La figure 16 est une vue de dessus du transistor 200, les figures 17 et 18 étant des vues en coupe respectivement selon les axes AA et BB représentés sur la figure 16.

Par rapport au dispositif 100 précédemment décrit dans lequel seules deux des quatre parois latérales de la tranchée d'isolation 114 s'étendent sous la zone active 110, les quatre parois latérales de la tranchée d'isolation 214 du dispositif 200 s'étendent toutes sous la zone active 110. Des portions diélectriques 118 sont donc présentes sous l'ensemble de la périphérie de la zone active 110.

Une telle tranchée d'isolation 214 est réalisée via une oxydation de l'ensemble des parois latérales de la tranchée au niveau de la première couche de semi-conducteur 104, par exemple de manière analogue à la réalisation des portions 118 du transistor 100 précédemment décrit. Les portions diélectriques 118 sont en contact avec la partie de la couche diélectrique 106 se trouvant sous la zone active 110. De manière avantageuse, une implantation d'oxygène et/ou de fluor selon les quatre directions des parois latérales est mise en oeuvre afin de faciliter l'oxydation latérale des parois de la tranchée.

## Revendications

1. Dispositif microélectronique (100) comportant au moins :
- un substrat (102) comprenant une première couche de semi-conducteur (108) disposée sur une couche diélectrique (106), la couche diélectrique (106) étant disposée sur une deuxième couche de semi-conducteur (104),
- une tranchée d'isolation (114) réalisée à travers la première couche de semi-conducteur (108), la couche diélectrique (106) et une partie de l'épaisseur de la deuxième couche de semi-conducteur (104), comprenant au moins un matériau diélectrique et délimitant, dans la première couche de semi-conducteur (108), au moins une zone active (110) du dispositif (100),
dans lequel, au niveau de ladite partie de l'épaisseur de la deuxième couche de semi-conducteur (104), au moins une partie (118) du matériau diélectrique de la tranchée d'isolation (114) est disposée sous la zone active (110), la zone active (110) étant de forme sensiblement rectangulaire et étant délimitée par au moins quatre parois latérales de la tranchée d'isolation (114) qui s'étendent à travers la première couche de semi-conducteur (108), la couche diélectrique (106) et ladite partie de l'épaisseur de la deuxième couche de semi-conducteur (104),
et dans lequel, au niveau de ladite partie de l'épaisseur de la deuxième couche de semi-conducteur (104), deux (118) des quatre parois latérales qui sont sensiblement parallèles l'une par rapport à l'autre sont disposées sous la zone active (110) et les deux autres parois latérales (120) ne sont pas disposées sous la zone active (110).

2. Dispositif microélectronique (100) selon la revendication 1, dans lequel ledit matériau diélectrique de la tranchée d'isolation (114) est du SiO₂.

3. Dispositif microélectronique (100) selon l'une des revendications précédentes, dans lequel ladite partie (118) du matériau diélectrique de la tranchée d'isolation (114) est en contact avec une partie de la couche diélectrique (106) qui est disposée sous la zone active (110).

4. Dispositif microélectronique (100) selon l'une des revendications précédentes, comportant en outre au moins un transistor réalisé dans la zone active (110) et dont une grille (111) est disposée sur une partie de la zone active (110) et sur une partie desdites deux autres parois latérales (120).

5. Dispositif microélectronique (100) selon l'une des revendications précédentes, dans lequel, au niveau de la couche diélectrique (106) et de la première couche de semi-conducteur (108), les parois latérales sont formées d'au moins une couche de nitrure de semi-conducteur (116).

6. Procédé de réalisation d'un dispositif microélectronique (100), comportant au moins la réalisation, dans un substrat (102) comprenant une première couche de semi-conducteur (108) disposée sur une couche diélectrique (106), la couche diélectrique (106) étant disposée sur une deuxième couche de semi-conducteur (104), d'au moins une tranchée d'isolation (114) à travers la première couche de semi-conducteur (108), la couche diélectrique (106) et une partie de l'épaisseur de la deuxième couche de semi-conducteur (104), comprenant au moins un matériau diélectrique et délimitant, dans la première couche de semi-conducteur (108), au moins une zone active (110) du dispositif (100),
et comportant, lors de la réalisation de la tranchée d'isolation (114), la réalisation d'une partie (118) du matériau diélectrique de la tranchée d'isolation (114, 214), au niveau de ladite partie de l'épaisseur de la deuxième couche de semi-conducteur (104), sous la zone active (110), la zone active (110) étant de forme sensiblement rectangulaire et étant délimitée par au moins quatre parois latérales de la tranchée d'isolation (114) qui s'étendent à travers la première couche de semi-conducteur (108), la couche diélectrique (106) et ladite partie de l'épaisseur de la deuxième couche de semi-conducteur (104), et dans lequel, au niveau de ladite partie de l'épaisseur de la deuxième couche de semi-conducteur (104), deux (118) des quatre parois latérales qui sont sensiblement parallèles l'une par rapport à l'autre sont disposées sous la zone active (110) et les deux autres parois latérales (120) ne sont pas disposées sous la zone active (110).

7. Procédé selon la revendication 6, dans lequel la réalisation de la tranchée d'isolation (114) comporte au moins la mise en oeuvre des étapes suivantes :
- gravure d'une tranchée (128) à travers la première couche de semi-conducteur (108), la couche diélectrique (106) et ladite partie de l'épaisseur de la deuxième couche de semi-conducteur (104),
- implantation d'oxygène et/ou de fluor dans une ou plusieurs parois latérales de la tranchée (128), au niveau de la deuxième couche de semi-conducteur (104),
- recuit du substrat (102), formant ladite partie (118) du matériau diélectrique de la tranchée d'isolation (114) disposée sous la zone active (110) dans ladite partie de l'épaisseur de la deuxième couche de semi-conducteur (104).

8. Procédé selon la revendication 7, dans lequel le recuit est mis en oeuvre sous atmosphère de dioxygène.

9. Procédé selon l'une des revendications 7 ou 8, dans lequel l'implantation d'oxygène et/ou de fluor est réalisée par des faisceaux d'ions d'énergie comprise entre environ 0,5 keV et 40 keV et/ou dont la dose est comprise entre environ 5.10¹³ at.cm² et 5.10¹⁶ at.cm², orientés en formant un angle non nul avec ladite une ou plusieurs parois latérales de la tranchée (128).

10. Procédé selon l'une des revendications 7 à 9, dans lequel l'implantation d'oxygène et/ou de fluor est également réalisée dans une paroi de fond de la tranchée (128).

11. Procédé selon l'une des revendications 6 à 10, comportant en outre, au cours de la réalisation de la tranchée d'isolation (114), une étape de réalisation d'au moins une couche de nitrure de semi-conducteur (116) formant des parois latérales de la tranchée d'isolation (114) au niveau de la couche diélectrique (106) et de la première couche de semi-conducteur (108).

12. Procédé selon l'une des revendications 6 à 11, comportant en outre, après la réalisation des parois latérales de la tranchée d'isolation (114), une étape de remplissage de la tranchée par au moins un matériau diélectrique (122).

13. Procédé selon l'une des revendications 6 à 12, comportant en outre, après la réalisation de la tranchée d'isolation (114), une étape de réalisation d'au moins un transistor dans la zone active (110) et dont une grille (111) est disposée sur une partie de la zone active (110) et sur une partie desdites deux autres parois latérales (120).
